# EUROPEAN PATENT SPECIFICATION

(11) **EP 3 691 144 B1**
(45) Date of publication and mention of the grant of the patent: **19.10.2022**
(21) Application number: 19154513.6
(22) Date of filing: 30.01.2019
(51) Int. Cl.: G01R 31/00, H04B 7/06, G01R 29/10, H04B 17/29, H04B 17/23

(54) **TEST SYSTEM, TEST METHOD, CONTROL SYSTEM AND CONTROL METHOD**
TESTSYSTEM, TESTVERFAHREN, STEUERUNGSSYSTEM UND STEUERUNGSVERFAHREN
SYSTÈME DE TEST, PROCÉDÉ DE TEST, SYSTÈME DE COMMANDE ET PROCÉDÉ DE COMMANDE

(43) Date of publication of application: 05.08.2020
(73) Proprietor: Rohde & Schwarz GmbH & Co. KG, 81671 München (DE)
(72) Inventor: NASEEF, Mahmud, 82152 Planegg (DE); REIMER, Christian, 83527 Haag i. OB. (DE)
(74) Representative: Isarpatent

(56) References cited:
- EP-A1- 3 273 257
- WO-A1-2017/096082
- US-A1- 2003 003 883

## Description

### TECHNICAL FIELD

The present invention relates to a test system and a test method for testing an over-the-air communication. The present invention further relates to a control system and a control method for testing an over-the-air communication.

### BACKGROUND

EP 3273257 A1 describes a system for measurement of a device under test with a first positioner having a first antenna and a second positioner having a second antenna. The system also includes circuitry which causes the first antenna to radiate a test signal to the DUT and to implement a probing mode or an interference mode.

US 2003/003883 A1 describes a testing chamber for evaluating the accuracy of a wireless communication device under test in a production environment. The configuration of the testing chamber may resemble an enclosed structure having a wall that includes multiple layers. An array of antennas, which serves as a layer of the wall, is strategically positioned within the testing chamber to receive and transmit signals emitted to/from the wireless communication device.

Even though applicable to any kind of device under test, the present invention and its underlying problem will be hereinafter described in connection with testing an over-the-air communication of a vehicle.

The use of wireless communication systems for communication between electronic devices increase continually with advance of high speed wireless data communications. During development and production of products comprising such communication devices, it is necessary to thoroughly test the communication devices for compliances with communication standards and legal regulations.

The use of wireless communication in modern cars also continuously increases. Hence, there is a need for thoroughly testing the wireless communication of the communication devices included in a vehicle. The wireless communication may be tested in a test chamber. Especially, it may be desirable to test the wireless communication from multiple azimuthal or longitudinal angles. For this purpose, multiple antennas may be arranged in the test chamber for testing the wireless communication from different angles. However, such a test arrangement with many antennas in a test chamber is expensive. Furthermore, the test arrangement is limited to the specific positions of the individual antennas.

Against this background, a problem addressed by the present invention is to provide a versatile and efficient testing of a wireless communication, in particular a testing of a wireless communication, which can realize a variable spatial angle of a communication link between a device under test and a test antenna.

### SUMMARY

The present invention solves this problem with a test system, a test method with the features of the independent claims. Further advantageous embodiments are subject-matter of the dependent claims.

The present invention is based on the finding that testing a communication link may require testing the communication link from multiple angular positions with respect to the device under test while maintaining the communication link. The present invention is further based on the finding that stimulating multiple angular positions by multiple test antennas requires a great effort, and such a test arrangement is limited to the specific positions of the individual test antennas.

The present invention therefore takes into account this finding and aims to provide a more versatile, flexible and efficient testing of a communication link of an over-the-air communication. Especially, the present invention suggests to change the spatial relationship between a device under test and a test antenna by moving or rotating at least the device under test. Additionally, it may be also possible to move around the test antenna with respect to the device under test. By such a movement and/or rotation of the device under test, it is possible to change the spatial relationship between the test antenna and the device under test in a very flexible manner. Accordingly, the maintaining of the communication link of an over-the-air communication between a device under test and test antenna can be tested in a very flexible way. Especially, only a minimum number of test antennas is required for such a test arrangement.

With the test system and the test method it is therefore not possible to test an over-the-air communication of a wireless communication link by changing the angular direction of the communication link with respect to the orientation of the device under test. In particular, it is even possible to change the angular orientation while maintaining the communication link between the device under test and a specific test antenna. In this way, it is possible to analyze the behavior of the wireless communication, in particular the communication link when the spatial relationship between the device under test and the test antenna changes over the time. In this way, a movement of the device under test in a real world scenario can be simulated.

Further to this, by means of the control system and the control method it is possible to visualize the communication link and/or the spatial positions of the antenna used for the wireless communication over the communication link. In this way, a user is still aware about the current configuration. Thus, it is possible to monitor the configuration of the test scenario, and to apply appropriate instructions for setting and/or controlling the operation during the test of the over-the-air communication. In particular, the configuration of the antennas and the resulting communication link can be supervised and controlled even if the active antennas in the test scenario cannot be directly recognized by the user.

The device under test may be any kind of communication device, which may establish an over-the-air communication by a wireless communication link. For example, the device under test may be a portable or mobile device, which may establish a wireless communication with a communication partner. The communication partner may be a further mobile device or a communication device at a fixed spatial position. For example, the communication partner may be a base station of a communication network or the like.

The device under test may be any kind of device comprising a communication device for establishing a wireless communication. In particular, the device under test may be, for example, a vehicle, for example, a car or a truck, a drone, a quadcopter etc. However, it is understood, that any other device under test comprising a communication device for establishing a wireless communication over a communication link may be also possible.

The mechanical positioning structure may be a device, which can carry the device under test as a whole. Furthermore, the positioning structure may move around the device under test with respect to the test antenna. For example, the mechanical positioning structure may be a platform on which the device under test may be located, and the platform may be moved around or rotated. For example, the platform carrying the device under test may be rotated around a predetermined axis, or the platform may be tilted. Additionally, or alternatively, the mechanical positioning structure may move the device under test in a longitudinal direction. For example, a linear drive may be used for moving the device under test. Furthermore, it may be possible to move the device under test in two or more linear directions. In this way, the device under test may be moved around on a two-dimensional plane or in a three-dimensional space. It is understood, that a linear movement may be combined with a rotation or a tilt.

The test antenna may be any appropriate antenna or antenna system for emitting and receiving wireless signals. The test antenna may be mounted on the support device at a fixed spatial position. However, it is also possible to move around the test antenna, as will be described in more detail below. The test antenna may be connected with the radio communication device. In this way, the test signals provided by the radio communication device may be emitted by the test antenna. Furthermore, radio frequency signals emitted by the device under test and received by the test antenna may be forwarded to the radio communication device. In particular, a bidirectional communication between the radio communication device and the device under test may be performed over the communication link, which is established between the test antenna and the device under test.

The visualization of the antennas and/or the antenna beams during the test will be described in more detail below. Further embodiments of the present invention are subject of the further sub-claims and of the following description referring to the drawings.

The test antenna comprises a beamforming antenna array.

By means of an antenna array comprising multiple antenna elements, it is possible to control the beam steering and the beam width of the antenna beam of the test antenna. In this way, it is possible to adapt the properties of the antenna beam of the test antenna. In particular, it may be possible to modify the radiation pattern of the test antenna with respect to the spatial position of the device under test.

In a possible embodiment, the test system comprises a beamforming device. The beamforming device is connected to the beamforming antenna array. The beamforming device is further adapted to perform a beam steering and/or beamforming of an antenna beam provided by the beamforming antenna array.

The beamforming device may control the radio frequency signals provided to the individual antenna elements of the test antenna and/or the individual radio frequency signals received by the antenna elements of the antenna array. For example, the phases of the individual signals provided by the antenna elements may be shifted to achieve the desired beamforming. However, any other signal processing may be applied for a beamforming of the test antenna.

The support device comprises a movable test antenna carrier. The movable test antenna carrier is adapted to carry the test antenna. In particular, the movable test antenna carrier is adapted to adjust a spatial position of the test antenna on the support device.

For example, the movable test antenna carrier may move the test antenna on the support device in a longitudinal direction. However, it may be also possible to rotate the test antenna on an axis, to tilt the test antenna or to perform any other movement of the test antenna on a two-dimensional plane or in a three-dimensional space.

The support device may have, for example, a structure of an arch. The arch may extend over the device under test. Accordingly, when moving the test antenna along the arch of the support device, the test antenna can be moved around over the device under test. By further moving/rotating the device under test by means of the mechanical positioning structure, it is possible to achieve almost an arbitrary angular relationship between the device under test and the test antenna.

In a possible embodiment, the test system comprises at least one further test antenna. The at least one further test antenna may be electrically connected to the radio communication device. The at least one further antenna may be further adapted to emit a radio frequency signal to the device under test and/or receive a radio frequency signal from the device under test.

By means of at least two test antennas, i.e. the test antenna and at least one further test antenna, tests with a multiple antenna configuration may be applied. For example, a handover from the test antenna to a further test antenna may be tested, the further test antenna may be used for emitting interfering signals or for simulating a simultaneous communication of the device under test with two communication partners by establishing a first communication link between the device under test and test antenna and a second communication link between the device under test and the further test antenna. However, even more than two communication links by two or more further test antennas may be established.

In a possible embodiment, the radio communication device is adapted to perform a handover of a communication link between the test antenna and the device under test to a communication link between the at least one further test antenna and the device under test.

Hence, by means of multiple test antennas, it is possible to perform any kind of test scenario requiring two or more antennas. By moving or rotating the device under test, it is possible to simulate even a handover in a test scenario with changing spatial relationships between the device under test and the test antennas.

In a possible embodiment, the test system comprises a further support device. The further support device may be adapted to carry the at least one further test antenna. In particular, the at least one further support device may carry one or more further test antennas. However, it is also possible to use multiple support devices, for example a separate support device for each further test antenna.

The test antennas may be mounted on the further support device at a fixed position. Alternatively, it may be possible to use further movable test antenna carriers for moving around the further test antennas on the further support devices.

In a possible embodiment, the test system comprises a monitoring device. The monitoring device may be adapted to monitor a spatial position and/or an antenna beam of the test antenna. Additionally, or alternatively, the monitoring device may be adapted to monitor a spatial position and/or an antenna beam of an antenna of the device under test.

The monitoring of the respective parameters may be performed in any appropriate manner. For example, optical markers may be mounted on the respective antennas, and the positions of the antennas may be monitored by one or more cameras. However, it may be also possible to determine the spatial positions of the respective antennas in advance and to compute a movement of the antennas based on the movement of the mechanical positioning structure moving the device under test and/or the movable test antenna carrier moving the test antenna. For example, the control signals to the mechanical positioning structure and/or the movable test antenna carrier may be forwarded to a processing device for computing the spatial positions of the antennas during the movement.

The antenna beam of the antennas may be determined, for example by analyzing an orientation of the respective antenna. For example, the orientation of an antenna may be determined based on an optical analysis of images captured by a camera. Additionally or alternatively, a movement of the respective antenna may be determined and analyzed in order to determine an orientation of the respective antenna beam. Furthermore, if the antenna beam of the test antenna and/or an antenna of the device under test is controlled by a beamforming device, the parameters used for the beamforming of the beamforming device may be forwarded to a processing device in order to compute the respective information of the antenna beam. However, any other scheme for determining a position of an antenna or for determining characteristic antenna parameters such as the antenna beam may be also possible.

In a possible embodiment, the test system comprises a visualization device. The visualization device may provide a visual representation of the spatial position and/or the antenna beam of the test antenna. Additionally or alternatively, a visual representation of the spatial position and the antenna beam of the antenna of the device under test may be provided.

For example, a two-dimensional representation of the test scenario may be displayed on a screen, and the relevant information such as the antenna positions and/or the antenna beams may be displayed on the screen. For example, the information relating to the antennas may be overlaid to a representation of the test scenario. It may be possible to indicate whether or not an antenna of the test scenario is currently an active antenna. Furthermore, an active communication link between an antenna of the device under test and a test antenna may be displayed. It is understood, that any other property of the test scenario, in particular any other property in connection with a communication link or an antenna may be displayed.

In a possible embodiment, the visualization device is adapted to provide a visualization of a movement of the test antenna and/or the antenna of the device under test.

For example, a track representing the movement of the respective antenna may be displayed. For example, time stamps may be assigned for specific positions of an antenna during the movement. The assigned time stamps may be displayed in a visualization of the movement of an antenna. However, any other appropriate scheme for representing a change of the properties in the test system, in particular of the antennas, may be applied.

In a possible embodiment, the visualization device is adapted to provide a visualization of a maximum beamforming capability of an antenna. In particular, a maximum beamforming capability of the test antenna and/or the antenna of the device under test may be provided.

For example, characteristic parameters of an antenna system may be acquired. Based on the characteristic parameters, a maximum or minimum angle of a beam steering capability or a maximum or minimum beam width may be determined. Further characteristic parameters may be also computed. The determined characteristic antenna parameters may be represented in a visualization of the test system, in particular a visualization of the antennas in the test system. In this way, the capabilities of the test system can be easily recognized, and thus, the control of the test system can be improved.

In a possible embodiment, the visualization device comprises a virtual reality platform or an augmented reality platform. In particular, the visualization device may comprise virtual reality glasses or augmented reality glasses.

By providing the visualization of the test scenario as a virtual reality scenario, a three-dimensional representation of the relevant information can be provided. For example, the whole test scenario may be represented as a virtual reality scenario, i.e. all information are provided on a display system such as virtual reality glasses.

Alternatively, it may be also possible to represent the test scenario as an augmented reality scenario. In an augmented reality scenario, a semitransparent display may overlay additional information to the optical perception of a user through the semitransparent display. Thus, a user may view the environment and at the same time obtain additional information provided by the displayed information in the semitransparent display.

In a possible embodiment, the test system comprises a measurement chamber. The test chamber may accommodate at least the test antenna, the support device, the mechanical positioning structure and the device under test. In particular, the measurement chamber may be an anechoic measurement chamber, i.e. a measurement chamber absorbing electromagnetic waves.

As with the test system, the control system may also comprise a visualization device performing the same functionality. Especially, the control system may comprise a visualization device with a virtual reality or augmented reality platform.

By the visualization of the antennas and/or the antenna properties of the test system, it is possible to monitor the configuration and the operation of the communication system by maintaining a communication link between a device under test and a test antenna. In this way, a user is still aware of the relevant information during the test of the over-the-air communication between a device under test and the test antenna. Especially, the movement of the device under test and/or the test antenna can be monitored and controlled in a very efficient manner such that the operation of the testing can be improved. Accordingly, the reliability of the test and the test results is enhanced, the required time for performing the whole test scenario can be reduced and thus, the costs for the testing can be minimized.

Thus, with the present invention it is therefore now possible to provide a testing of an over-the-air communication by a communication link between a device under test and a test antenna when the spatial relationship between a test antenna and a device under test is changed. By moving and/or rotating the device under test with respect to the test antenna, it is possible to simulate an almost arbitrary relationship between a device under test and the test antenna. The operation of the test, in particular the movement of the device under test with respect to the test antenna can be improved by visualization of the related antennas and the antenna properties.

### BRIEF DESCRIPTION OF THE DRAWINGS

For a more complete understanding of the present invention and advantages thereof, reference is now made to the following description taking in conjunction with the accompanying drawings. The invention is explained in more detail below using exemplary embodiments, which are specified in the schematic figures and the drawings, in which:
- Fig. 1:: shows a schematic diagram of a cross-section of a test system according to an embodiment of the present invention;
- Fig. 2:: shows a schematic illustration of a test system according to an embodiment;
- Fig. 3:: shows a schematic illustration of a perspective view of a test system according to an embodiment;
- Fig. 4:: shows a visual representation provided by a system according to an embodiment;
- Fig. 5:: shows a visual representation provided by a system according to a further embodiment;
- Fig. 6:: shows a schematic illustration of a visualization device according to an embodiment;
- Fig. 7:: shows a flow diagram illustrating a test method according to an embodiment; and
- Fig. 8:: shows a flow diagram of a control method according to an embodiment.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown in scale.

In the drawings, same, functionally equivalent and identical operating elements, features and components are provided with same reference signs in each case, unless stated otherwise.

### DETAILED DESCRIPTION OF THE DRAWINGS

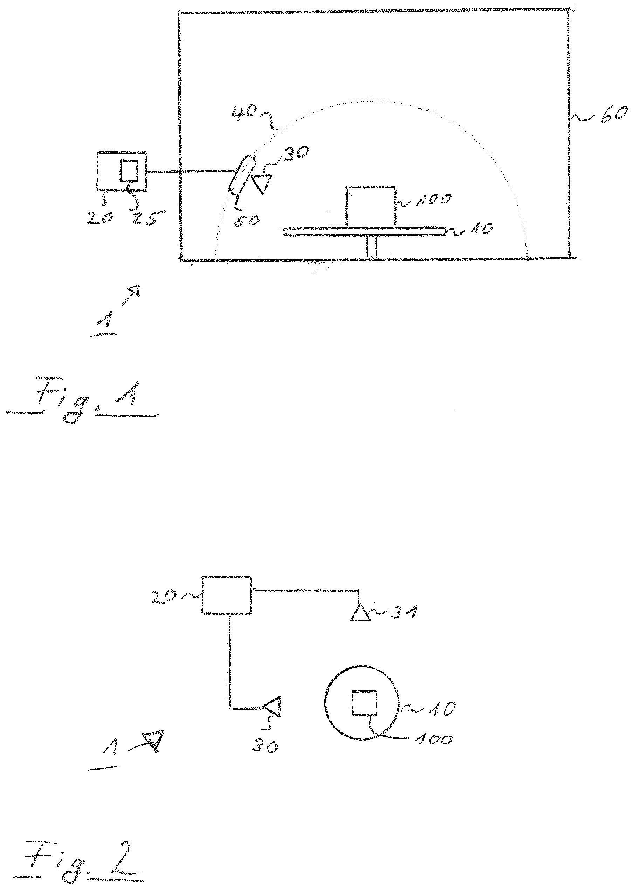

Figure 1 shows a schematic diagram of a cross-section through a test system 1 according to an embodiment. The test system 1 comprises a mechanical positioning structure 10. The mechanical positioning structure 10 may provide a platform or the like for carrying a device under test 100. The device under test 100 may be a communication device, in particular a wireless communication device, or a device comprising a wireless communication device. For example, the device under test 100 may be a vehicle such as a car. The device under test may also be, for example, a drone, a quadcopter or any other device comprising a wireless communication device for establishing a communication link with a communication partner. The device under test 100 may be rigidly fastened on the mechanical positioning structure 10, in particular on a platform of the mechanical positioning structure 10.

The mechanical positioning structure 10 may be adapted to rotate the device under test 100 or move the device under test 100 in a longitudinal direction. For example, the mechanical positioning structure 10 may rotate the platform with the device under test 100 around a predetermined axis. Furthermore, it may be possible that the device under test 100, in particular the platform with the device under test 100 may be tilted. Additionally or alternatively, the device under test 100 may be moved in a longitudinal direction on a two-dimensional plane. Furthermore, it may be even possible to move the device under test 100 by the mechanical positioning structure 10 in a three-dimensional space. For this purpose, the mechanical positioning structure 10 may comprise one or more driving elements, such as motors or the like.

The test system 1 further comprises a test antenna 30. The test antenna 30 may emit wireless signals, in particular radio frequency signals to the device under test 100. Additionally or alternatively, the test antenna 30 may receive wireless signals, in particular radio frequency signals, from the device under test 100.

The test antenna 10 may be connected with a radio communication device 20. Radio communication device 20 may generate radio frequency signals, which are provided to the test antenna for emitting the radio frequency signals to the device under test 100. Furthermore, test antenna 30 may forward radio frequency signals received from the device under test 100 to the radio communication device 20. In this way, a communication link between the test antenna 30 and the device under test 100 is established. Furthermore, the radio communication device 20 aims to maintain the established communication link between the test antenna 30 and the device under test 100 when testing the over-the-air communication of the device under test 100.

Since the device under test 100 is moved and/or rotated by the mechanical positioning structure 10 during the test of over-the-air communication of the device under test 100, the spatial relationship between the device under test 100 and the test antenna 30 may change over the time. For maintaining the communication link between the device under test 100 and the test antenna 30, it may be appropriate to adapt the radiation direction of the test antenna 30 accordingly. For example, test antenna 30 may be mounted on a movable test antenna carrier 50. Movable test antenna carrier 50 may pan or tilt test antenna 30 in order to adapt the direction of radiation of test antenna 50. Furthermore, movable test antenna carrier 50 may move around the test antenna 30 in a three-dimensional space, on a two-dimensional plane or along a specific track. For example, a support device 40 may be provided, and mechanical positioning structure 50 may move around the test antenna 30 along the support device 40. In this way, it is possible to adapt the spatial relationship between test antenna 30 and the device under test 100. However, it may be also possible to mount test antenna 30 on a fixed position on the support device 40. In this case, the spatial relationship between the test antenna 30 and the device under test 100 can be only modified by moving or rotating the device under test 100 by the mechanical positioning structure 10.

Furthermore, test antenna 30 comprises a beamforming antenna array. A beamforming antenna array may comprise multiple antenna elements, which are arranged along a line or on two-dimensional area. By individually providing each antenna element with a specific radio frequency signal, the radiation pattern of the beamforming antenna array can be adapted. In this way, the radiation pattern and in particular the beam steering can be adapted accordingly. Furthermore, when receiving radio frequency signals, it may be also possible to achieve a beamforming of the antenna pattern of the antenna area by individually processing the radio frequency signal from each antenna area element. For performing the beamforming of the antenna area of the test antenna 30, a beamforming device 25 may perform the required processing of the radio frequency signals.

The test system 1, in particular the mechanical positioning structure 10 with the device under test 100, the test antenna 30 and the support device 40 for carrying the test antenna may be arranged in a measurement chamber 60. In particular, the measurement chamber 60 may be an anechoic measurement chamber. For this purpose, the measurement chamber 60 may comprise a shielding or protecting housing that isolates the test system from any outside interference or disturbance during the measurements. The measurement chamber may comprise, for example, a door or a sealable opening for accessing the inside of the measurement chamber, for example to place the device under test 100 in the measurement chamber 60.

The interior surfaces of the anechoic chamber 60 may be covered with radiation absorbing materials. In this way, reflections or the like may be absorbed by the radiation absorbing material to avoid the risk of measurement errors or ambiguities.

By establishing and maintaining a radio communication link between the test antenna 30 and the device under test 100, and further moving around or rotating the device under test 100 and/or the test antenna 30, the behavior of the communication device of the device under test 100 can be monitored while maintaining the communication link. In particular, any characteristic parameter of the over-the-air communication between the device under test 100 and the test antenna 30 may be monitored and evaluated while changing the spatial relationship between the device under test 100 and the test antenna 30. For example, it may be evaluated if the communication device in the device under test 100 performs a handover from a first antenna of the device under test 100 to a second device of the device under test 100. Furthermore, a beamforming capability of an antenna area of a communication device of the device under test 100 may be evaluated by measuring a signal strength of a signal received by the test antenna 30. However, it is understood, that any other property of the communication device in the device under test 100 may be measured or evaluated.

Fig. 2 shows a schematic block diagram of a test system 1 according to a further embodiment. The embodiment according to Figure 2 mainly corresponds to the previously described embodiment. Further to this, the embodiment according to Figure 2 additionally comprises at least one further test antenna 31. The at least one further test antenna 31 may be mounted on a same support device 40, which has been used for carrying the test antenna 30. However, it may be also possible to use one or more additional support devices for carrying the at least one further test antenna 31. The at least one further test antenna 31 may be mounted on a fixed spatial position. However, it may be also possible to use further movable test antenna carriers for moving around the at least one further test antenna 31.

By using one or more further test antenna 31, it may be possible to establish multiple communication links between the device under test 100 and the test antenna 30 and the further test antenna 31. In this way, a simultaneous communication over multiple communication links may be tested. Furthermore, it may be also possible to perform a handover from test antenna 30 to a further test antenna 31 and to test and evaluate this handover procedure. In particular, the testing may be also performed by moving or rotating the device under test 100. Additionally or alternatively, it may be also possible to move test antenna 30 and/or further test antenna 31.

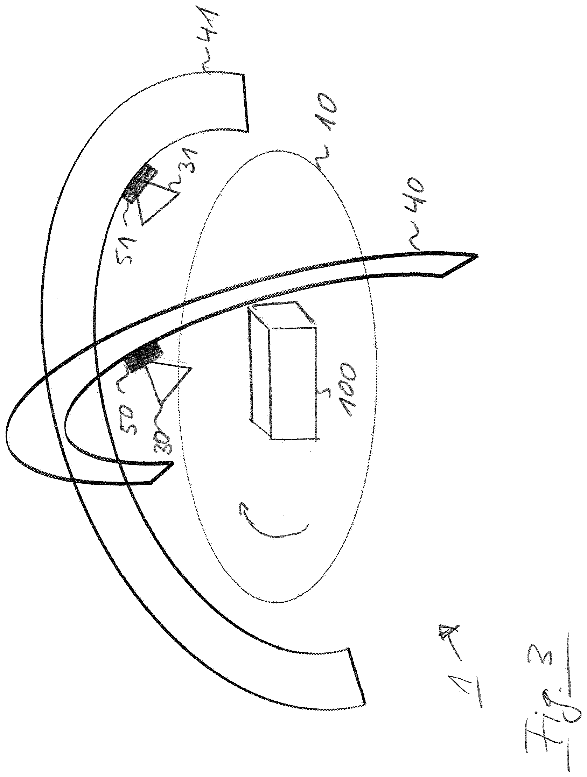

Figure 3 shows a perspective view of a test system 1 according to a further embodiment. The test antenna in Figure 3 mainly corresponds to the previously described test system 1. As can be seen in Figure 3, test antenna 30 may be carried by a support device 40. As already described above, test antenna 30 may be mounted at a fixed position or may be moved around by a movable test antenna carrier 50 on the support device 40. A further test antenna 31 may be carried by a further support device 41. Further test antenna 31 may be also mounted on the fixed position on the further support device 41. Alternatively, the further test antenna 31 may be moved around by a further movable test antenna carrier 51. As can be seen in Figure 3, the support devices 40, 41 may have a structure of an arch. In this way, it may be possible to move the antennas 30, 31 from one side over the top to another side of the device under test 100. In particular, the arch of the support device 40 carrying the test antenna 30 may be arranged rectangular to the arch of the further support device 41 carrying the further test antenna 31. However, any other relationship or shape of the support devices 40, 41 may be also possible.

During the testing of the over-the-air communication of the device under test 100, the device under test 100 may be rotated or moved around by mechanical positioning structure 10. Furthermore, it may be possible to move around test antenna 30 and, if applicable, further test antenna 31. Accordingly, the spatial relationship between the antennas of the communication device in the device under test 100 and the test antennas 30, 31 may change over the time of the test. For this purpose it may be desirable to monitor the spatial positions of the respective antennas. Furthermore, the configuration of the individual antennas, in particular the radiation pattern of the relevant antennas might be also of interest. The information about the antennas 30, 31 of the test system 1 and, if possible, information about the antennas in the communication device of the device under test 100 might be determined and monitored. For example, control information for moving and rotating the antennas 30, 31 of the test system 1 may be analyzed in order to determine the spatial position and the orientation of the respective antennas 30, 31. Furthermore, the operational parameters of beam steering device 25 for controlling the beam steering of test antenna 30 and an antenna area of the further test antennas 31 may be also taken into account for determining the radiation pattern of the respective antennas. In addition, the operation of the mechanical positioning structure 10 may be also taken into account for acquiring information about the positions and orientation of the antennas of the communication device of the device under test 100. Any other information about the test antennas 30, 31 and the antennas of the communication device of the device under test 100 may be also taken to account for acquiring information of the radiation patterns.

The information about the radiation patterns such as the direction of radiation and the beam width or any other relevant information may be monitored and recorded. For example, a monitoring device may be used for acquiring and processing the required information. Furthermore, the information may be displayed on a visualization device. The information relating to the antennas may be provided on a display such as a two-dimensional screen. Furthermore, it may be also possible to provide the visualization on a three-dimensional visualization device, in particular virtual reality glasses or the like. This will be described in more detail below.

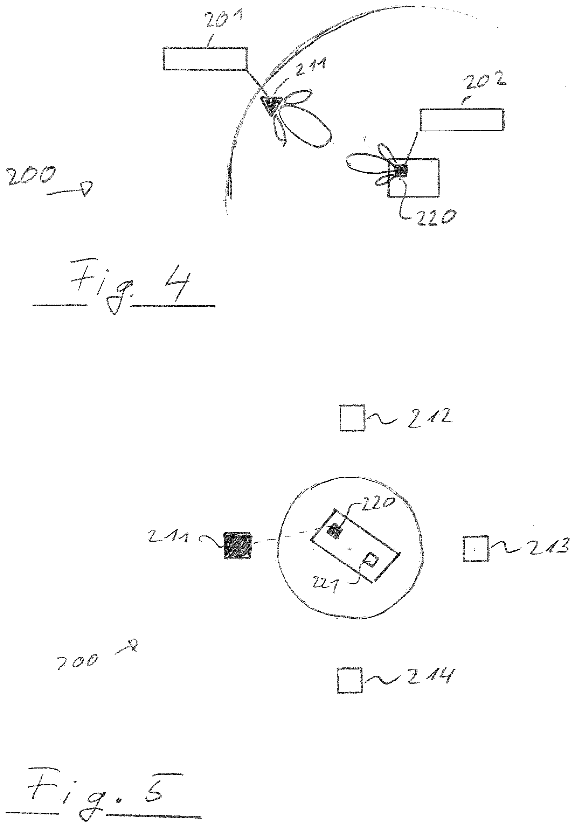

Figure 4 shows an example of a visualization 200. The visualization 200 may display, for example a cross-section of a test arrangement. For example, this visualization may be generated by a control system comprising the test system 1 as described above and a visualization device for displaying visual representation of the test antenna 30 and the antennas of the communication system of the device under test 100. As can be seen, for example, in Figure 4, it may be possible to provide a schematic representation of the test arrangement illustrating the spatial position of a test antenna 211 and a spatial position of an antenna 220 of the communication device of the device under test 100. Furthermore, it may be possible to provide a schematic illustration of a radiation pattern of the respective antennas 211, 220. Optionally, additional information boxes 201, 202 may be provided for displaying additional information with respect to the respective antennas. For example, a received or emitted signal strength may be displayed, information about a bit error rate, a frequency, a modulation or any other relevant parameter may be displayed in the respective information boxes 201, 202.

Figure 5 shows a further example of a visualization 200 according to an embodiment. In this example, a top view of a test arrangement is displayed. Active antennas are illustrated by a solid box, and inactive antennas may be displayed by an empty box. In this example, four test antennas 211-214 are illustrated. Furthermore, an antenna 220 of the communication system of the device under test 100 may be also illustrated. The device under test 100 may be rotated in a clockwise direction. As can be seen in this example, the communication link is established and maintained between the antenna 220 of the device under test 100 and the first antenna 211.

In order to illustrate the movement of the individual antennas, it may be possible to display a track of the respective antennas 211-214 and/or 220. Furthermore, time stamp information may be provided for displaying the respective point of time when the antenna was at the respective position. Any other kind of information be also provided in the visualization 200.

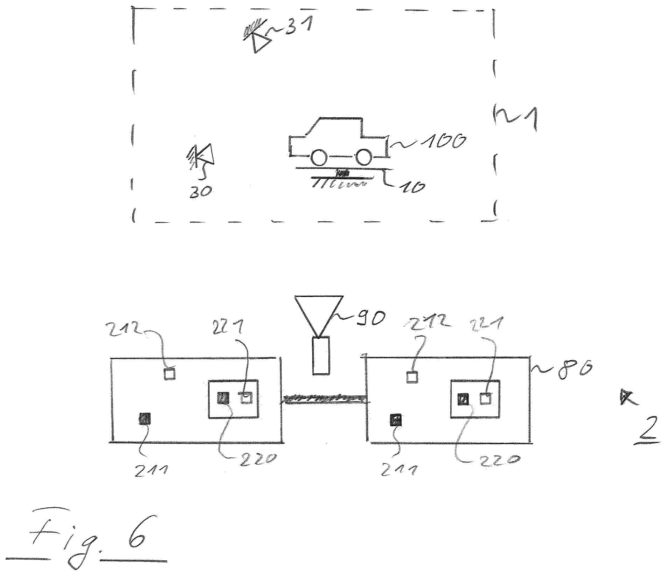

Figure 6 shows a schematic illustration of a control system 2 for monitoring the operation of a test procedure for testing an over-the-air communication of a device under test 100. The control system 2 may comprise a test system 1 as described above. Furthermore, a visualization of the arrangement may be provided by a visualization device 80. As already mentioned above, visualization device 80 may comprise a two-dimensional screen or a three-dimensional visualization device. For example, visualization device 80 may comprise virtual reality glasses or augmented reality glasses.

Further to the visualization device 80, the control system 2 may comprise a camera 90 for capturing images of the test arrangement. In this way, the captured test arrangement may be overlaid with the additional information, in particular the information regarding the antennas. Additionally or alternatively, the images of camera 90 may be also used for determining the position of the test antennas 30, 31 and/or the device under test 100. Camera 90 may be mounted at a fixed spatial position. Alternatively, camera 90 may be mounted on the visualization device 80. In this way, the orientation of the individual elements with respect to the visualization device 80 can be determined.

As can be seen in Figure 6, visualization device 80 may illustrate, for example, the positions of the test antennas 211, 212 and/or the positions of the antennas 220, 221 in the communication device of the device under test 100. In particular, active antennas may be marked by an appropriate indication. For example, active antennas may be marked by a specific color or, as illustrated in Figure 6, by solid boxes. Any other scheme for illustrating active and inactive antennas may be also possible.

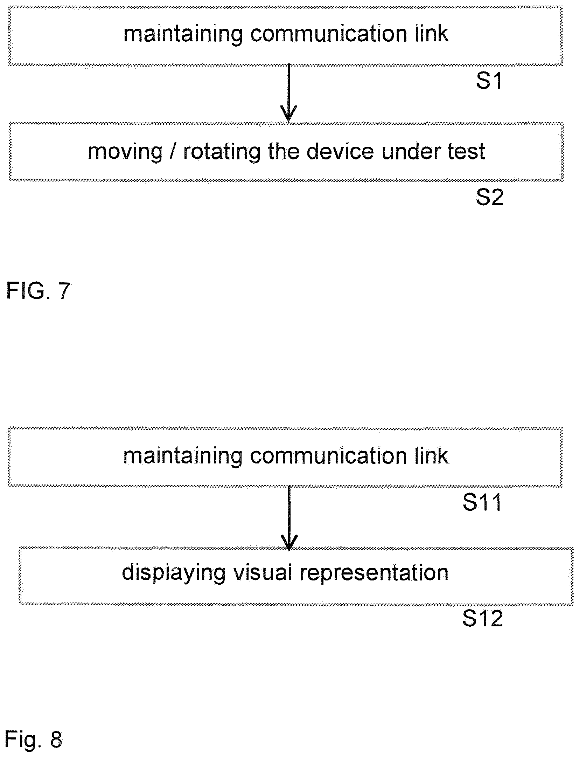

Figure 7 shows a flow diagram of a test method for testing an over-the-air communication of a device under test 100. The test method comprises a step S1 of maintaining a communication link between a test antenna 30 and a device under test 100. The communication link may be established between the device under test and the test antenna carried by a support device.

While maintaining the communication link and performing the test, the method comprises a step s2 of moving and/or rotating the device under test 100. In particular, the device under test may be moved and/or rotated by a mechanical positioning structure 10.

Figure 8 shows a flow diagram of a control method for controlling a test of an over-the-air communication of a device under test 100. In a step S11, a communication link between a test antenna 30 and a device under test 100 is established, and in step S12, a visualization of a spatial position and/or an antenna beam of the test antenna 30 and/or an antenna of the device under test 100 is displayed. In particular, the visual representation 200 may be displayed on a virtual reality platform or an augmented reality platform. For example, the representation may be provided by virtual reality glasses or augmented reality glasses.

In particular, the virtual representation 200 may provide a track of a moving test antenna 30, 31 and/or a moving antenna of the device under test.

Summarizing, the present invention relates to testing an over-the-air communication of a device under test. The device under test is moved or rotated by a moving platform while a communication link between the device under test and a test antenna is maintained. In this way, the communication capabilities of a communication system in the device under test can be tested while the spatial relationship between the device under test and a test antenna is changed. The spatial position and the properties of the related antennas are monitored and a visual representation is provided by visualization device, in particular by a virtual or augmented reality platform for controlling the test.

## Claims

1. Test system (1) for testing an over-the-air communication of a device under test (100), the test system (1) comprising:
a mechanical positioning structure (10) adapted to move and/or rotate the device under test (100);
a test antenna (30) adapted to emit wireless signals to the device under test (100) and/or receive wireless signals from the device under test (100), wherein the test antenna (30) comprises a beamforming antenna array;
a support device (40) adapted to carry the test antenna (30) wherein the support device (40) comprises a movable test antenna carrier (50) adapted to carry the test antenna (30), wherein the movable test antenna carrier (50) is adapted to adjust a position of the test antenna (30) on the support device (40); and
a radio communication device (20) connected to the test antenna and adapted to establish a communication link between the test antenna (30) and the device under test (100) and to maintain the communication link between the test antenna (30) and the device under test (100) while moving around or rotating the device under test (100).

2. Test system (1) according to claim 1, comprising a beamforming device (25) connected to the beamforming antenna array, the beamforming device (25) is adapted to perform a beam steering and/or beamforming of an antenna beam provided by the beamforming antenna array.

3. Test system (1) according to claim 1 or 2, comprising at least one further test antenna (31) electrically connected to the radio communication device (20), the least one further test antenna (31) is adapted to emit wireless signals to the device under test (100) and/or receive wireless signals from the device under test (100).

4. Test system (1) according to claim 3, wherein the radio communication device (20) is adapted to perform a handover of the communication link between the test antenna (30) and the device under test (100) to a communication link between the at least one further test antenna (31) and the device under test (100).

5. Test system (1) according to claim 3 or 4, comprising a further support device (41), adapted to carry the at least one further test antenna (31).

6. Test system (1) according to any of claims 1 to 5, comprising a monitoring device adapted to monitor a spatial position and/or an antenna beam of the test antenna (30) and/or an antenna of the device under test (100).

7. Test system (1) according to claim 6, wherein the monitoring device is adapted to assign time stamp information to the monitored the spatial position and/or the antenna beam of the test antenna (30) and/or the antenna of the device under test (100).

8. Test system (1) according to any of claims 1 to 7, comprising a visualization device (80) adapted to provide a visual representation (200) of the spatial position and/or the antenna beam of the test antenna (30) and/or the antenna of the device under test (100).

9. Test system (1) according to claim 8, wherein the visualization device (80) is adapted to provide a visualization of a movement of the test antenna (30) and/or the antenna of the device under test (100).

10. Test system (1) according to claim 8 or 9, wherein the visualization device (80) is adapted to provide a visualization of a maximum beam forming capability of the test antenna (30) and/or the antenna of the device under test (100).

11. Test system (1) according to any of claims 8 to 10, wherein the visualization device (80) comprises a virtual reality or augmented reality platform, in particular virtual reality glasses or augmented reality glasses.

12. Test system (1) according to any of claims 1 to 11, comprising an anechoic measurement chamber (60) that accommodates the test antenna (30), the support device (40), the mechanical positioning structure (10) and the device under test (100) .

13. Test method for testing an over-the-air communication of a device under test (100), the test method comprising:
maintaining (S1) a communication link between a test antenna (30) and a device under test (100),
wherein the test antenna (30) comprises a beamforming antenna array, the test antenna (30) is carried by a movable test antenna carrier (50) for adjusting a position of the test antenna (30) on the support device (40);
wherein the communication link is established between the device under test (100) and the test antenna (30) carried by a support device (40), and
wherein the device under test (100) is moved and/or rotated (S2) by a mechanical positioning structure (10) while maintaining (S1) the communication link between the test antenna (30) and a device under test (100).

14. Control system (2) for controlling a test of an over-the-air communication of a device under test (100), the control system (2) comprising:
a test system (1) according to any of claims 1 to 12; and
a visualization device (80) adapted to display a visual representation of a spatial position and/or an antenna beam of the at least one test antenna (30,31) and/or an antenna of the device under test (100).

15. Control system (2) according to claim 14, wherein the visualization device (2) comprises a virtual reality or augmented reality platform, in particular virtual reality glasses or augmented reality glasses.

16. Control method for controlling a test of an over-the-air communication of a device under test (100), wherein the test is performed by
the test method according to claim 13; and
displaying (S12) a visual representation of a spatial position and/or an antenna beam of the test antenna (30) and/or an antenna of the device under test (100).

17. Control method according to claim 16, wherein displaying the visual representation comprises outputting a track of a moving the test antenna (30) and/or a moving antenna of the device under test (100).

18. Control method according to claim 16 or 17, wherein displaying the visual representation comprises displaying a handover of the communication link between the test antenna (30) and the device under test (100) to a communication link between at least one further test antenna (31) and the device under test (100) or to a communication link between the test antenna (30) and at least one further antenna of the device under test (100).

## Patentansprüche

1. Testsystem (1) zum Testen einer Über-die-Luft-Kommunikation einer zu testenden Vorrichtung (100), wobei das Testsystem (1) Folgendes umfasst:
eine mechanische Positionierungsstruktur (10), die angepasst ist, die zu testende Vorrichtung (100) zu bewegen und/oder zu drehen;
eine Testantenne (30), die angepasst ist, drahtlose Signale an die zu testende Vorrichtung (100) zu emittieren und/oder drahtlose Signale von der zu testenden Vorrichtung (100) zu empfangen, wobei die Testantenne (30) ein Strahlformungsantennenarray umfasst;
eine Stützvorrichtung (40), die angepasst ist, die Testantenne (30) zu tragen, wobei die Stützvorrichtung (40) einen bewegbaren Testantennenträger (50) umfasst, der angepasst ist, die Testantenne (30) zu tragen, wobei der bewegbare Testantennenträger (50) angepasst ist, eine Position der Testantenne (30) auf der Stützvorrichtung (40) anzupassen; und
eine Funkkommunikationsvorrichtung (20), die mit der Testantenne verbunden und angepasst ist, zwischen der Testantenne (30) und der zu testenden Vorrichtung (100) einen Kommunikationslink herzustellen und den Kommunikationslink zwischen der Testantenne (30) und der zu testenden Vorrichtung (100) beizubehalten, während die zu testende Vorrichtung (100) herumbewegt oder gedreht wird.

2. Testsystem (1) nach Anspruch 1, das eine Strahlformvorrichtung (25) umfasst, die mit dem Strahlformungsantennenarray verbunden ist, wobei die Strahlformvorrichtung (25) angepasst ist, eine Strahllenkung und/oder eine Strahlformung eines Antennenstrahls, der vom Strahlformungsantennenarray bereitgestellt wird, durchzuführen.

3. Testsystem (1) nach Anspruch 1 oder 2, das mindestens eine weitere Testantenne (31) umfasst, die elektrisch mit der Funkkommunikationsvorrichtung (20) verbunden ist, wobei die mindestens eine weitere Testantenne (31) angepasst ist, drahtlose Signale an die zu testende Vorrichtung (100) zu emittieren und/oder drahtlose Signale von der zu testenden Vorrichtung (100) zu empfangen.

4. Testsystem (1) nach Anspruch 3, wobei die Funkkommunikationsvorrichtung (20) angepasst ist, eine Übergabe des Kommunikationslinks zwischen der Testantenne (30) und der zu testenden Vorrichtung (100) an einen Kommunikationslink zwischen der mindestens einen weiteren Testantenne (31) und der zu testenden Vorrichtung (100) durchzuführen.

5. Testsystem (1) nach Anspruch 3 oder 4, das ferner eine Stützvorrichtung (41) umfasst, die angepasst ist, die mindestens eine weitere Testantenne (31) zu tragen.

6. Testsystem (1) nach einem der Ansprüche 1 bis 5, das eine Überwachungsvorrichtung umfasst, die angepasst ist, eine Raumposition und/oder einen Antennenstrahl der Testantenne (30) und/oder eine Antenne der zu testenden Vorrichtung (100) zu überwachen.

7. Testsystem (1) nach Anspruch 6, wobei die Überwachungsvorrichtung angepasst ist, der überwachten Raumposition und/oder dem Antennenstrahl der Testantenne (30) und/oder der Antenne der zu testenden Vorrichtung (100) Zeitstempelinformationen zuzuweisen.

8. Testsystem (1) nach einem der Ansprüche 1 bis 7, das eine Visualisierungsvorrichtung (80) umfasst, die angepasst ist, eine visuelle Repräsentation (200) der Raumposition und/oder des Antennenstrahls der Testantenne (30) und/oder der Antenne der zu testenden Vorrichtung (100) bereitzustellen.

9. Testsystem (1) nach Anspruch 8, wobei die Visualisierungsvorrichtung (80) angepasst ist, eine Visualisierung einer Bewegung der Testantenne (30) und/oder der Antenne der zu testenden Vorrichtung (100) bereitzustellen.

10. Testsystem (1) nach Anspruch 8 oder 9, wobei die Visualisierungsvorrichtung (80) angepasst ist, eine Visualisierung eines Maximums einer Strahlformungsfähigkeit der Testantenne (30) und/oder der Antenne der zu testenden Vorrichtung (100) bereitzustellen.

11. Testsystem (1) nach einem der Ansprüche 8 bis 10, wobei die Visualisierungsvorrichtung (80) eine Plattform für die virtuelle Realität oder die erweiterte Realität umfasst, insbesondere eine Brille für die virtuelle Realität oder die erweiterte Realität.

12. Testsystem (1) nach einem der Ansprüche 1 bis 11, das eine echogene Messkammer (60) umfasst, in der sich die Testantenne (30), die Stützvorrichtung (40), die mechanische Positionierungsstruktur (10) und die zu testende Vorrichtung (100) befinden.

13. Testverfahren zum Testen einer Über-die-Luft-Kommunikation einer zu testenden Vorrichtung (100), wobei das Testverfahren Folgendes umfasst:
Beibehalten (S1) eines Kommunikationslinks zwischen einer Testantenne (30) und einer zu testenden Vorrichtung (100),
wobei die Testantenne (30) ein Strahlformungsantennenarray umfasst, die Testantenne (30) zum Anpassen einer Position der Testantenne (30) auf der Stützvorrichtung (40) von einem bewegbaren Testantennenträger (50) getragen wird;
wobei der Kommunikationslink zwischen der zu testenden Vorrichtung (100) und der Testantenne (30), die von einer Stützvorrichtung (40) getragen wird, hergestellt ist und
wobei die zu testende Vorrichtung (100) von einer mechanischen Positionierungsstruktur (10) bewegt und/oder gedreht (S2) wird, während der Kommunikationslink zwischen der Testantenne (30) und einer zu testenden Vorrichtung (100) beibehalten (S1) wird.

14. Steuersystem (2) zum Steuern eines Tests einer Überdie-Luft-Kommunikation einer zu testenden Vorrichtung (100), wobei das Steuersystem (2) Folgendes umfasst:
ein Testsystem (1) nach einem der Ansprüche 1 bis 12 und
eine Visualisierungsvorrichtung (80), die angepasst ist, eine visuelle Repräsentation einer Raumposition und/oder eines Antennenstrahls der mindestens einen Testantenne (30, 31) und/oder einer Antenne der zu testenden Vorrichtung (100) anzuzeigen.

15. Steuersystem (2) nach Anspruch 14, wobei die Visualisierungsvorrichtung (80) eine Plattform für die virtuelle Realität oder die erweiterte Realität umfasst, insbesondere eine Brille für die virtuelle Realität oder die erweiterte Realität.

16. Steuerverfahren zum Steuern eines Tests einer Überdie-Luft-Kommunikation einer zu testenden Vorrichtung (100), wobei der Test durch das Testverfahren nach Anspruch 13 durchgeführt wird; und
Anzeigen (S12) einer visuellen Repräsentation einer Raumposition und/oder eines Antennenstrahls der Testantenne (30) und/oder einer Antenne der zu testenden Vorrichtung (100).

17. Steuerverfahren nach Anspruch 16, wobei das Anzeigen der visuellen Repräsentation das Ausgeben eines Wegs des Bewegens der Testantenne (30) und/oder einer sich bewegenden Antenne der zu testenden Vorrichtung (100) umfasst.

18. Steuerverfahren nach Anspruch 16 oder 17, wobei das Anzeigen der visuellen Repräsentation das Anzeigen einer Übergabe des Kommunikationslinks zwischen der Testantenne (30) und der zu testenden Vorrichtung (100) an einen Kommunikationslink zwischen mindestens einer weiteren Testantenne (31) und der zu testenden Vorrichtung (100) oder an einen Kommunikationslink zwischen der Testantenne (30) und mindestens einer weiteren Antenne der zu testenden Vorrichtung (100) umfasst.

## Revendications

1. Système de test (1) pour tester une communication par liaison radio d'un dispositif à l'essai (100), le système de test (1) comprenant :
une structure de positionnement mécanique (10) adaptée pour déplacer et/ou faire tourner le dispositif à l'essai (100) ;
une antenne de test (30) adaptée pour émettre des signaux sans fil vers le dispositif à l'essai (100) et/ou recevoir des signaux sans fil à partir du dispositif à l'essai (100), dans lequel l'antenne de test (30) comprend un réseau d'antennes de formation de faisceau ;
un dispositif de support (40) adapté pour porter l'antenne de test (30), dans lequel le dispositif de support (40) comprend un porte-antenne de test mobile (50) adapté pour porter l'antenne de test (30), dans lequel le porte-antenne de test mobile (50) est adapté pour régler une position de l'antenne de test (30) sur le dispositif de support (40) ; et
un dispositif de communication radio (20) connecté à l'antenne de test et adapté pour établir une liaison de communication entre l'antenne de test (30) et le dispositif à l'essai (100) et pour maintenir la liaison de communication entre l'antenne de test (30) et le dispositif à l'essai (100) tout en se déplaçant autour du dispositif à l'essai (100) ou en le faisant tourner.

2. Système de test (1) selon la revendication 1, comprenant un dispositif de formation de faisceau (25) connecté au réseau d'antennes de formation de faisceau, le dispositif de formation de faisceau (25) est adapté pour réaliser une orientation de faisceau et/ou une formation de faisceau d'un faisceau d'antenne fourni par le réseau d'antennes de formation de faisceau.

3. Système de test (1) selon la revendication 1 ou 2, comprenant au moins une antenne de test supplémentaire (31) connectée électriquement au dispositif de communication radio (20), l'au moins une antenne de test supplémentaire (31) est adaptée pour émettre des signaux sans fil vers le dispositif à l'essai (100) et/ou recevoir des signaux sans fil à partir du dispositif à l'essai (100).

4. Système de test (1) selon la revendication 3, dans lequel le dispositif de communication radio (20) est adapté pour réaliser un transfert de la liaison de communication entre l'antenne de test (30) et le dispositif à l'essai (100) vers une liaison de communication entre l'au moins une antenne de test supplémentaire (31) et le dispositif à l'essai (100).

5. Système de test (1) selon la revendication 3 ou 4, comprenant un dispositif de support supplémentaire (41), adapté pour porter l'au moins une antenne de test supplémentaire (31).

6. Système de test (1) selon l'une quelconque des revendications 1 à 5, comprenant un dispositif de surveillance adapté pour surveiller une position spatiale et/ou un faisceau d'antenne de l'antenne de test (30) et/ou d'une antenne du dispositif à l'essai (100).

7. Système de test (1) selon la revendication 6, dans lequel le dispositif de surveillance est adapté pour attribuer des informations d'horodatage à la position spatiale et/ou au faisceau d'antenne surveillés de l'antenne de test (30) et/ou de l'antenne du dispositif à l'essai (100).

8. Système de test (1) selon l'une quelconque des revendications 1 à 7, comprenant un dispositif de visualisation (80) adapté pour fournir une représentation visuelle (200) de la position spatiale et/ou du faisceau d'antenne de l'antenne de test (30) et/ou de l'antenne du dispositif à l'essai (100).

9. Système de test (1) selon la revendication 8, dans lequel le dispositif de visualisation (80) est adapté pour fournir une visualisation d'un déplacement de l'antenne de test (30) et/ou de l'antenne du dispositif à l'essai (100).

10. Système de test (1) selon la revendication 8 ou 9, dans lequel le dispositif de visualisation (80) est adapté pour fournir une visualisation d'une capacité de formation de faisceau maximale de l'antenne de test (30) et/ou de l'antenne du dispositif à l'essai (100).

11. Système de test (1) selon l'une quelconque des revendications 8 à 10, dans lequel le dispositif de visualisation (80) comprend une plateforme de réalité virtuelle ou de réalité augmentée, notamment des lunettes de réalité virtuelle ou des lunettes de réalité augmentée.

12. Système de test (1) selon l'une quelconque des revendications 1 à 11, comprenant une chambre de mesure anéchoïque (60) qui accueille l'antenne de test (30), le dispositif de support (40), la structure de positionnement mécanique (10) et le dispositif à l'essai (100).

13. Procédé de test pour tester une communication par liaison radio d'un dispositif à l'essai (100), le procédé de test comprenant les étapes consistant à :
maintenir (S1) une liaison de communication entre une antenne de test (30) et un dispositif à l'essai (100),
dans lequel l'antenne de test (30) comprend un réseau d'antennes de formation de faisceau, l'antenne de test (30) est portée par un porte-antenne de test mobile (50) pour régler une position de l'antenne de test (30) sur le dispositif de support (40) ;
dans lequel la liaison de communication est établie entre le dispositif à l'essai (100) et l'antenne de test (30) portée par un dispositif de support (40), et
dans lequel le dispositif à l'essai (100) est déplacé et/ou mis en rotation (S2) par une structure de positionnement mécanique (10) tout en maintenant (S1) la liaison de communication entre l'antenne de test (30) et un dispositif à l'essai (100).

14. Système de commande (2) pour commander un test d'une communication par liaison radio d'un dispositif à l'essai (100), le système de commande (2) comprenant :
un système de test (1) selon l'une quelconque des revendications 1 à 12 ; et
un dispositif de visualisation (80) adapté pour afficher une représentation visuelle d'une position spatiale et/ou d'un faisceau d'antenne de l'au moins une antenne de test (30, 31) et/ou d'une antenne du dispositif à l'essai (100).

15. Système de commande (2) selon la revendication 14, dans lequel le dispositif de visualisation (80) comprend une plateforme de réalité virtuelle ou de réalité augmentée, notamment des lunettes de réalité virtuelle ou des lunettes de réalité augmentée.

16. Procédé de commande pour commander un test d'une communication par liaison radio d'un dispositif à l'essai (100), dans lequel le test est réalisé par le procédé de test selon la revendication 13 ; et
afficher (S12) une représentation visuelle d'une position spatiale et/ou d'un faisceau d'antenne de l'antenne de test (30) et/ou d'une antenne du dispositif à l'essai (100).

17. Procédé de commande selon la revendication 16, dans lequel l'affichage de la représentation visuelle comprend la sortie d'une piste d'un déplacement de l'antenne de test (30) et/ou d'un déplacement de l'antenne du dispositif à l'essai (100).

18. Procédé de commande selon la revendication 16 ou 17, dans lequel l'affichage de la représentation visuelle comprend l'affichage d'un transfert de la liaison de communication entre l'antenne de test (30) et le dispositif à l'essai (100) vers une liaison de communication entre au moins une antenne de test supplémentaire (31) et le dispositif à l'essai (100) ou vers une liaison de communication entre l'antenne de test (30) et au moins une antenne supplémentaire du dispositif à l'essai (100).
